## Europäisches Patentamt

## European Patent Office

## Office européen des brevets

(11) Veröffentlichungsnummer: **0 071 255**

**A2**

(12) # EUROPÄISCHE PATENTANMELDUNG

(21) Anmeldenummer: 82106802.0

(22) Anmeldetag: 27.07.82

(51) Int. Cl.³: **G 06 K 19/06**

(30) Priorität: 30.07.81 DE 3130206

(43) Veröffentlichungstag der Anmeldung:
09.02.83 Patentblatt 83/6

(84) Benannte Vertragsstaaten:
DE FR GB NL

(71) Anmelder: SIEMENS AKTIENGESELLSCHAFT
Berlin und München Wittelsbacherplatz 2
D-8000 München 2(DE)

(72) Erfinder: Ullrich, Hans, Dr. rer.nat.
Platanenstrasse 3
D-8021 Taufkirchen(DE)

(72) Erfinder: Schmitter, Detlev, Ing.grad.
Risserkogelstrasse 2
D-8000 München 80(DE)

(72) Erfinder: Rohde, Volker, Ing. grad.
Buchenstrasse 10a
D-8011 Forstinning(DE)

(54) Tragbare Karte zur Informationsverarbeitung.

(57) Die Erfindung betrifft eine tragbare Karte zur Informationsverarbeitung mit einem in der Karte angeordneten Halbleiterchip (5) und mit äußeren Anschlußbereichen (3), die mit den Kontaktierungsflächen (17) des Halbleiterchips (5) durch ein Leiternetz (6) verbunden sind. Der Halbleiterchips (5) ist in Form eines Mikropacks, bestehend aus einem Kunststoffzwischenträger (7), der mit einem eine größere Fläche als der Halbleiterchip (5) aufweisenden Fenster (8) versehen ist und der einseitig mit einem metallischen Leiternetz (6) versehen ist, dessen zum Kontaktieren der Kontaktierungsflächen (17) bestimmte Anschlußfinger (18) in das Fenster (8) hineinragen, wobei die Kontaktierungsflächen (17) des Halbleiterchips (5) zur elektrischen Kontaktierung und zur mechanischen Halterung des Chips (5) mit dem in das Fenster (8) hineinragenden Enden der Anschlußfinger (18) kontaktiert sind, in der aus einem Kartenkörper (2) und mindestens einer Deckfolie (25) bestehenden Karte (4) angeordnet. Das Mikropack ist als in eine fensterartige Aussparung (21) des Kartenkörpers (2) einpaßbare Einheit (1), deren Dicke in etwa der Dicke des Kartenkörpers (2) entspricht und auf deren einer Oberfläche die äußeren Anschlußbereiche (3) angeordnet sind, hergestellt.

FIG 4

EP 0 071 255 A2

0071255

SIEMENS AKTIENGESELLSCHAFT          Unser Zeichen
Berlin und München                  VPA 81 P 1103 E

Tragbare Karte zur Informationsverarbeitung

Die Erfindung betrifft eine tragbare Karte zur Informationsverarbeitung mit einem in der Karte angeordneten Halbleiterchip und mit äußeren Anschlußbereichen, die mit den Kontaktierungsflächen des Halbleiterchips durch ein Leiternetz verbunden sind.

Entsprechende tragbare Karten, die beispielsweise die Form üblicher Kreditkarten oder Scheckkarten aufweisen und in deren Halbleiterchip beispielsweise außer den unveränderlichen persönlichen Daten des Karteninhabers auch der Kontostand des Karteninhabers, der sich je nach Buchung bzw. Benutzung der Kreditkarte ändert, gespeichert ist, sind z. B. aus der DE-OS 22 20 721 und der DE-OS 26 33 164 bekannt.

Aus der DE-OS 26 59 573 ist eine tragbare Karte mit einer Anordnung zur Verarbeitung von elektrischen Signalen, die im Inneren der Karte angeordnet ist, und mit äußeren Kontaktklemmen, die mit der Anordnung durch ein Leiternetz verbunden sind, bekannt, bei der die Anordnung und das Leiternetz auf ein und demselben Substrat ruhen, dessen Dicke und dessen Flächeninhalt relativ kleiner sind als der Flächeninhalt der Karte und bei der die Anordnung in einem Hohlraum der Karte untergebracht ist und die Kontaktklemmen durch Kontaktbereiche der Leiter des Netzes über Aussparungen in der Karte gebildet sind.

Nte 1 Hub / 23.07.1981

Bei dieser Bauart ist das Justieren der Kontaktbereiche der Leiter des Netzes und der Aussparungen der Karte zueinander kompliziert und technisch aufwendig. Die aus Substrat, Anordnung und Leiternetz bestehende Einheit weist unterschiedliche Dicken auf, so daß diese Einheit bei Prüfvorgängen und beim Einbau in die tragbare Karte schlecht handhabbar ist. Insbesondere besteht die Gefahr, daß das die Anordnung und die äußeren Kontaktklemmen verbindende Leiternetz beim Einbau in die tragbare Karte wegen der unflexiblen Verbindung zwischen Kontaktklemmen und Anordnung zerstört wird bzw. teilweise abreißt.

Aufgabe der Erfindung ist es, hier Abhilfe zu schaffen, und eine tragbare Karte zur Informationsverarbeitung vorzusehen, die eine geringe Bauhöhe aufweist, fertigungstechnisch einfach herstellbar und handhabbar ist und bei der der Halbleiterchip ohne Komplikationen in die Karte eingebaut werden kann.

Diese Aufgabe wird bei einer Karte der eingangs genannten Art erfindungsgemäß dadurch gelöst, daß der Halbleiterchip in Form eines Mikropacks, bestehend aus einem Kunststoffzwischenträger, der mit einem eine größere Fläche als der Halbleiterchip aufweisenden Fenster versehen ist und der einseitig mit einem metallischen Leiternetz versehen ist, dessen zum Kontaktieren der Kontaktierungsflächen bestimmte Anschlußfinger in das Fenster hineinragen, wobei die Kontaktierungsflächen des Halbleiterchips zur elektrischen Kontaktierung und zur mechanischen Halterung des Chips mit dem in das Fenster hineinragenden Enden der Anschlußfinger kontaktiert sind, in der aus einem Kartenkörper und mindestens einer Deckfolie bestehenden Karte angeordnet ist und daß das Mikropack als in eine fensterartige Aussparung des Kartenkörpers einpaßbare Einheit, deren Dicke in etwa der Dicke des Kartenkörpers entspricht und auf deren einer Oberfläche
die äußeren Anschlußbereiche angeordnet sind, hergestellt
ist.

Durch Verwendung eines nach Art eines Mikropacks in der
Karte angeordneten Halbleiterchips wird eine geringe
Bauhöhe der Karte und eine Flexibilität des den Halbleiterchip kontaktierenden Leiternetzes ermöglicht. Das Anordnen von Mikropack und äußeren Anschlußbereichen als
separate in eine fensterartige Aussparung des Kartenkörpers einpaßbare Einheit ermöglicht die getrennte Herstellung von Karte und Halbleiterchip beinhaltender Einheit. Der empfindliche Teil der Karte kann klein gehalten
werden und  die Karte kann außerhalb des Bereichs der den
Halbleiterchip beinhaltenden Einheit beliebig flexibel
gestaltet werden. Sowohl die Einheit als auch die fertige
Karte sind völlautomatisch prüfbar, die einheitliche Dicke
der Einheit verhindert eine Zerstörung des Leiternetzes
und ermöglicht einen komplikationsfreien Einbau.

Stabilität der tragbaren Karte und Schutz der einpaßbaren
Einheit vor äußeren und mechanischen Einflüssen wird in
einfacher Weise dadurch erreicht, daß auf der Unterseite
der aus Kartenkörper und einpaßbarer Einheit gebildeten
Anordnung eine erste Deckfolie angeordnet ist und daß
auf der Oberseite der aus Kartenkörper und einpaßbarer
Einheit gebildeten Anordnung eine zweite, die Anschlußbereiche aussparende Deckfolie angeordnet ist.

Zur weiteren Erhöhung der Stabilität ist es von Vorteil,
die Hohlräume zwischen erster und zweiter Deckfolie mit
Kunststoff auszufüllen.

Es liegt im Rahmen der Erfindung, daß der Kunststoffzwischenträger auf einer, in die fensterartige Aussparung einpaßbaren, das Unterteil der einpaßbaren Einheit bildenden Bodenanordnung angeordnet ist und daß über dem Kunststoffzwischenträger eine die äußeren Anschlußbereiche aussparende in die fensterartige Aussparung einpaßbare und das Oberteil der einpaßbaren Einheit bildende Deckelfolie angeordnet ist.

In Weiterbildung der Erfindung ist vorgesehen, als Bodenanordnung eine Bodenfolie vorzusehen oder als Bodenanordnung ein mit einem eine größere Fläche als der Halbleiterchip aufweisenden Hohlraum versehenes Formstück vorzusehen.

Ebene Oberflächen der den Halbleiterchip enthaltenden tragbaren Karte werden vorteilhafterweise dadurch erreicht, daß die mit dem Leiternetz verbundenen, auf dem Kunststoffzwischenträger befindlichen äußeren Anschlußbereiche in ihrer Dicke verstärkt sind und daß die äußeren Anschlußbereiche so verstärkt sind, daß die aus den verstärkten äußeren Anschlußbereichen und der zweiten Deckfolie bestehende Oberfläche der Karte plan ist.

Zur Verhinderung statischer Aufladungen liegt es im Rahmen der Erfindung, daß die Bodenanordnung aus einem elektrisch leitenden Material hergestellt ist, daß die Deckelfolie aus einem elektrisch leitenden Material hergestellt ist, daß die metallisierte Rückseite des Halbleiterchips an der aus elektrisch leitendem Material hergestellten Folie oder Anordnung elektrisch leitend ist und/oder daß mindestens eine Deckfolie aus elektrisch leitendem Material hergestellt ist.

Vorteilhafterweise sind die aus elektrisch leitendem Material hergestellten Folien oder Anordnungen mit dem den Massekontakt bildenden äußeren Anschlußbereich elektrisch leitend verbunden.

Die Erfindung wird im folgenden anhand der Figuren näher erläutert. Es zeigen:

Fig. 1  ein Ausführungsbeispiel für einen Kartenkörper mit eingepaßter einpaßbarer Einheit in Draufsicht,

Fig. 2  eine erfindungsgemäße tragbare Karte, bei der über der in Fig. 1 dargestellten, aus Kartenkörper und einpaßbarer Einheit gebildeten Anordnung eine zweite, die Anschlußbereiche aussparende Deckfolie angeordnet ist, in Draufsicht,

Fig. 3  einen Längsschnitt durch ein Ausführungsbeispiel einer erfindungsgemäßen einpaßbaren Einheit längs der Linie III-III der Fig. 1, -

Fig. 4  ausschnittsweise einen Längsschnitt durch die als Ausführungsbeispiel in der Fig. 2 gezeigten Karte längs der Linie IV-IV der Fig. 2 und

Figuren 5 bis 8  ausschnittsweise Längsschnitte durch weitere Ausführungsbeispiele der in der Fig. 2 gezeigten Karte längs der Linie IV-IV der Fig. 2.

In den Figuren sind gleiche Elemente mit gleichen Bezugszeichen bezeichnet.

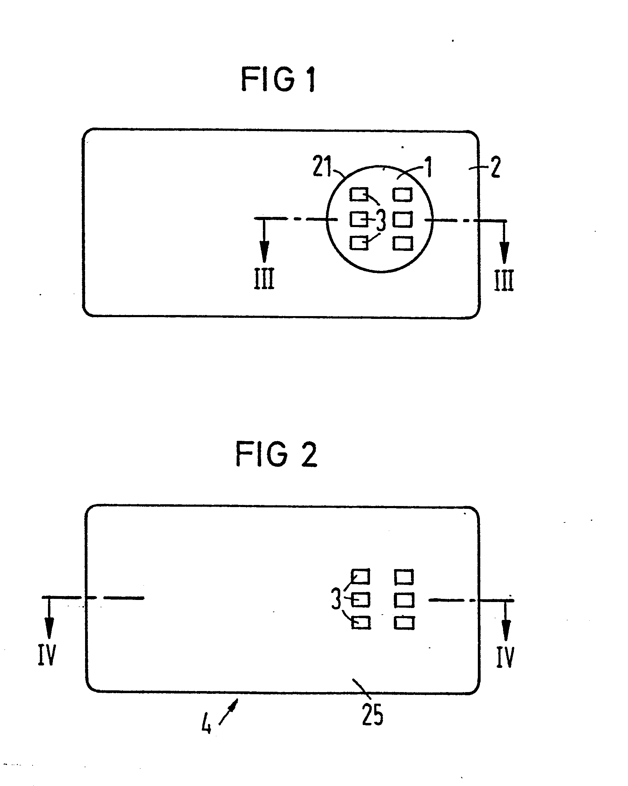

Das Ausführungsbeispiel nach Fig. 1 zeigt einen im wesentlichen rechteckigen tragbaren Kartenkörper 2, der z. B. entsprechend der geltenden europäischen Scheckkartennorm eine Breite von 53,98 ± 0,05 mm und eine Länge von 85,6 ± 0,12 mm aufweist. Die Dicke des z. B. aus Thermoplastfolie hergestellten Kartenkörpers 2 beträgt beispielsweise 0,5 mm. Der Kartenkörper 2 weist vorteilhafterweise eine fensterartige Aussparung 21 auf, in die die Einheit 1, in der sich ein Halbleiterchip in Form eines Mikropacks befindet, einpaßbar ist. Auf einer Oberfläche der Einheit 1 sind mit den Kontaktierungsflächen des Halbleiterchips verbundene Anschlußbereiche 3 angeordnet.

Auf der Unterseite der aus Kartenkörper 2 und einpaßbarer Einheit 1 gebildeten Anordnung ist eine erste Deckfolie angeordnet, während auf der Oberseite der aus
Kartenkörper 2 und anpaßbarer Einheit 1 bestehenden Anordnung eine zweite, die Anschlußbereiche 3 aussparende Deckfolie 25 angeordnet ist. Eine entsprechend ausgeführte
Karte 4 ist in Draufsicht in der Fig. 2 gezeigt.

Die Anschlußbereiche 3 können bei Durchlauf der Karte 4
durch ein nicht dargestelltes Lesegerät abgetastet werden.
Der in der Einheit 1 enthaltene Halbleiterchip kann beispielsweise Funktionen wie Serien-/Parallelwandler,
Parallel/Serienwandler, Schutzcodespeicher, Vergleichsschaltung, Datenspeicher für Identitätscode, Datenspeicher
für Bankdaten und eine Verschlüsselungslogik für das
Ausgangssignal aufweisen. Wie in den Figuren 1 und 2 gezeigt, können beispielsweise sechs äußere Anschlußbereiche
3 für je einen seriellen Informationsausgang, seriellen
Informationseingang, Takteingang, Eingang für eine Programmierspannung, Bezugspotential (Masse) und Versorgungsspannung vorgesehen sein.

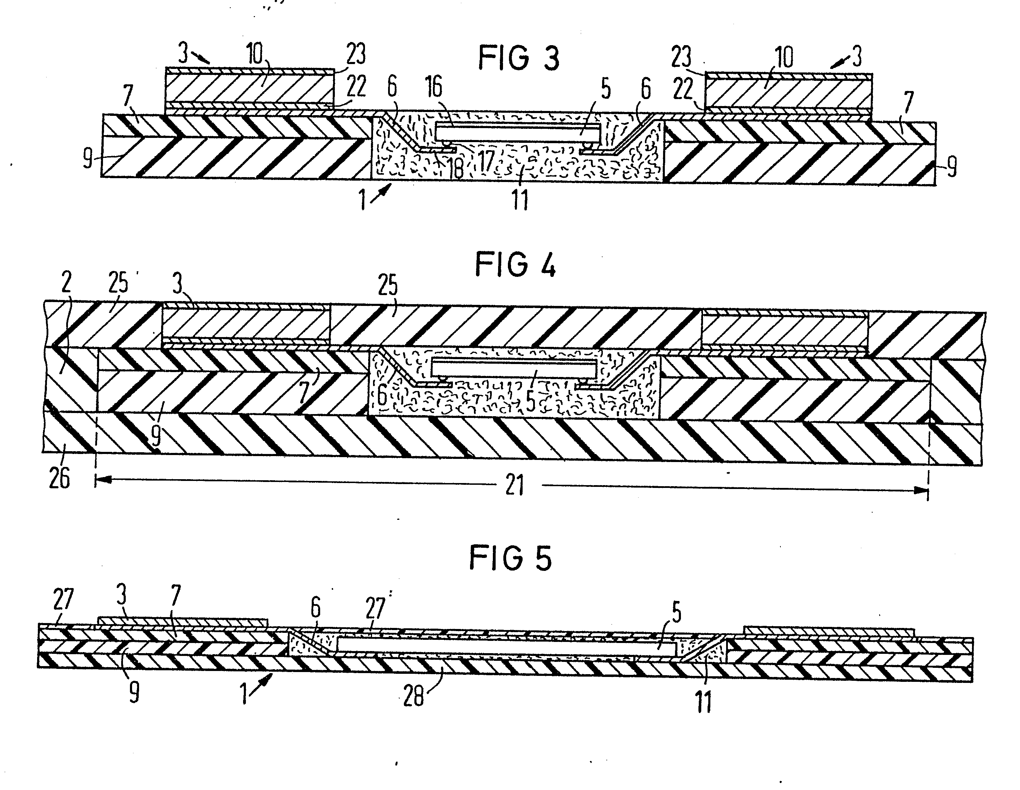

Der innere Aufbau der Einheit 1 ist in der Fig. 3, die
einen Querschnitt durch das Ausführungsbeispiel der Fig. 1
längs der Linie III-III zeigt, ausgeführt. Um insbesondere
eine geringe Bauhöhe der Karte 4 zu erreichen, wird der
Halbleiterchip 5 in Form eines Mikropacks kontaktiert
und in der Einheit 1 angeordnet. Der Aufbau eines Mikropacks ist in der DE-PS 20 23 680, der DE-PS 24 14 297 oder
in der Zeitschrift Siemens-Bauteilereport 16 (1978),
Heft 2, Seiten 40 bis 44 näher erläutert. Als Ausgangsmaterial dient vorzugsweise ein 35 mm breites hochtemperaturfestes Polyimidband 7, das gestanzt und z. B.
entsprechend den Maßen eines Super-8-Filmes nach DIN 15851
perforiert wird. Hersteller und Anwender können daher für die benötigten Fertigungsanlagen auf die Antriebs- und Fördertechnik der Filmindustrie zurückgreifen.

Vor der Montage der integrierten Schaltungen wird auf das Polyimidband 7 eine Kupferfolie aufgeklebt, partiell galvanisch verzinnt und so geätzt, daß Leiterbahnen 6 und Anschlußpunkte 18 für die Chips entstehen.

Nach dem Schneiden des breiten Filmstreifens in vier schmale Super-8-Bänder oder z. B. zwei 16-mm-Bänder werden die hermetisch versiegelten und mit lötfähigen Anschlüssen 17 versehenen Halbleiterchips 5 in den Film 7 eingelötet und zusätzlich mit einem Lacktropfen als Berührungsschutz abgedeckt. Da die feinen Kupferanschlüsse 6 frei in das Fenster 8 im Polyimidband 7 hereinragen, sind die integrierten Schaltungen flexibel gehaltert und so gegen mechanische und thermische Verspannung geschützt. Anschließend kann das so hergestellte Mikropack Stück für Stück vom Polyimidband 7 geschnitten werden. Bei einer Dicke des Chips 5 von o,25 ± 0,3 mm läßt sich mittels eines Mikropacks ohne Schwierigkeiten eine Gesamtbauhöhe für die Karte 4 von 0,76 ± 0,08 mm (europäische Scheckkartennorm) und eine gute Flexibilität der Einheit 1 erreichen.

Die Dicke von Polyimidband 7 und Leiternetz 6 beträgt typischerweise knapp 0,2 mm, wobei auf das 125 $\mu$m dicke Polyimidband 7 eine 25 $\mu$m dicke Kleberschicht, dann eine 35 $\mu$m dicke Kupferfolie, die an ihrer Oberseite mit einer 6 $\mu$m dicken Zinnschicht bedeckt ist, angebracht wird.

Um diese Dicke von etwa 200 $\mu$m auf die gewünschte Dicke des Kartenkörpers 2 von 500 $\mu$m zu vergrößern, ist es von Vorteil, die Einheit 1 zu verdicken und damit gleichzeitig zu versteifen, wodurch ein eventueller Bruch des Chips 5 verhindert wird. Diese Verdickung kann in einfacher Weise dadurch geschehen, daß der Kunststoffzwischenträger 7 auf einer Trägerfolie 9 angeordnet wird, die vorteilhafterweise solche Außenabmessungen aufweist, daß sie in die fensterartige Aussparung 21 des Kartenkörpers 2 einpaßbar ist, d. h. in Geometrie und Abmessungen der Aussparung 21 entspricht. Die Trägerfolie 9 kann beispielsweise durch Laminieren (Kleben unter Druck und Wärme) mit dem Kunststoffzwischenträger 7 verbunden werden. Ihre Dicke kann z. B. inklusive einer notwendigen Klebeschicht etwa 300 μm betragen.

Die Trägerfolie 9 wird vorteilhafterweise an der Seite des Kunststoffzwischenträgers 7, die nicht mit dem metallischen Leiternetz 6 versehen ist, angebracht. Als Material für die Trägerfolie 9 können Kunststoffe wie Epoxidharz, insbesondere glasfaserverstärktes Epoxidharz, Hartpapier oder Kapton und Metalle, wie insbesondere Messing, aber auch Kupfer, Nickel-Eisen oder Bronze zur Anwendung kommen.

Die Verwendung eines entsprechend dickeren Polyimidbandes 7 bei der Herstellung des Mikropacks hätte dagegen eine schlechtere Festigkeit zur Folge.

Um, falls gegebenenfalls auch auf der Seite des Kunststoffzwischenträgers 7, auf der das Leiternetz 6 angeordnet ist, eine weitere Folie auflaminiert werden soll, die Oberfläche der Einheit 1 mit den äußeren Anschlußbereichen 3 des Leiternetzes 6 abzuschließen oder allgemein eine ebene Oberfläche der Einheit 1 oder der Karte 4 zu schaffen, ist in Weiterentwicklung der Erfindung vorgesehen, die zunächst eine dem übrigen Leiternetz 6 entsprechende Dicke aufweisenden äußeren Anschlußbereiche 3 in ihrer Dicke zu verstärken. Dies kann in einfacher Weise durch Aufbringen eines metallischen Grundmaterials 10 auf dem als äußeren Anschlußbereich vorgesehenen Teil des Leiternetzes 6 erreicht werden.

Das Aufbringen des metallischen Grundmaterials 10 kann durch Löten, Schweißen oder Kleben erfolgen. Als metallisches Grundmaterial wird vorteilhafterweise ein unedles Metall, beispielsweise Messing, Federbronze, Nickel-Eisen oder Kupfer verwendet. Besonders einfach ist das metallische Grundmaterial 10 mittels der bekannten "Reflow-Soldering"-Methode auf das Leiternetz 6 aufzulöten, da sich dann eine Selbstjustierung ergibt.

Die zum Leiternetz 6 hingewandten Oberflächen der metallischen Verdickung 10 werden durch Plattieren oder galvanische Behandlung mit einer leitfähigen und ggf. lötfähigen Oberfläche 22 aus Zinn, Silber oder Gold versehen. Wird das Leiternetz 6 mit der metallischen Verdickung 10 verklebt, so kann ein elektrisch leitfähiger Kleber entweder direkt an der Unterseite der metallischen Verdickung 10 angeordnet werden, oder auf einer in einer der oben beschriebenen Weisen angebrachten metallischen, den Übergangswiderstand zwischen Metallverdickung 10 und Leiternetz 6 gering haltenden Oberflächenschicht 22 angebracht werden.

Auf die, die äußeren Kontaktbereiche 3 bildenden Oberfläche der metallischen Verdickungen 10 kann zur Erhöhung der Verschleißfestigkeit und um eine Kontaktfläche mit niedrigem Übergangswiderstand zu erreichen, mittels Plattierung oder mittels eines galvanischen Verfahrens eine weitere metallische Oberflächenschicht 23 aus Gold, Chrom, Nickel oder Silber angebracht werden.

Die Dicke des metallischen Grundmaterials 10 bzw. des Grundmaterials 10 und der Schichten 22 und 23 wird so gewählt, daß die Dicke der Einheit 1 der Dicke der Karte 4 entspricht; es ist aber auch möglich, die Anschlußflächen 3 so zu verdicken, daß sie aus der Oberfläche der Karte 4 herausschauen.

Auf diese Weise gelingt es, ohne auf eine bestimmte Technologie angewiesen zu sein, metallische Verdickungen 10 aufzubringen, für die kostengünstige Materialien verwendbar sind. Da von unterschiedlichen Materialien und unterschiedlichen Oberflächen ausgegangen werden kann, können zahlreiche Verfahren verwendet werden, so daß die Wahl der entsprechenden Technologie flexibel gestaltet werden kann.

Der innere Aufbau der Karte 4 ist in der Fig. 4, die einen ausschnittsweisen Querschnitt durch die Karte der Fig. 2 längs der Linie IV-IV zeigt, ausgeführt. Die in der Fig. 3 gezeigte einpaßbare Einheit 1, die im gezeigten Ausführungsbeispiel so ausgeführt ist, daß die Dicke von Kunststoffzwischenträger 7 und Trägerfolie 9 der Dicke des Kartenträgers 2 entspricht, wird in die fensterartige Aussparung 21 des Kartenträgers 2 gepreßt. Auf der Unterseite der aus Kartenkörper 2 und einpaßbarer Einheit 1 gebildeten Anordnung wird eine erste Deckfolie 26 angeordnet, die in ihren äußeren Abmessungen den Abmessungen des Kartenkörpers 2 entspricht. Auf der Oberseite der aus Kartenkörper 2 und einpaßbarer Einheit 1 gebildeten Anordnung wird eine zweite, die Anschlußbereiche 3 aussparende Deckfolie 25 angeordnet, deren äußere Abmessungen ebenfalls denen des Kartenkörpers 2 entsprechen.

Auf diese Weise gelingt es, eine insbesondere Normmaßen entsprechende tragbare Karte herzustellen, die eine ebene Oberfläche aufweist. Kartenträger 2 und die Deckfolien 25 und 26 können aus glasfaserverstärktem Epoxid oder aus Thermoplastkunststoff bestehen und mittels Laminieren verbunden werden. Hierbei ist es beim Aufbringen der zweiten Deckfolie 25 von Vorteil, die Aussparungen der Deckfolie 25, die die Anschlußbereiche 3 aufnehmen sollen, geringfügig kleiner als es der Fläche der Anschlußbereiche 3 entspricht, auszuführen und die zweite Deckfolie 25 von oben auf die Anschlußbereiche 3 bzw. den Trägerkörper 2 zu pressen, da so die Einheit 1 abgedichtet und vor Verunreinigungen geschützt ist.

Die zwischen erster Deckfolie 26 und zweiter Deckfolie 25 bzw. zwischen den verstärkten Anschlußbereichen 3 und der Trägerfolie 9 auftretenden Hohlräume können durch Vergießen oder durch Verspritzen mit - in der Fig. 4 gepunktet gezeichnetem - Kunststoff 11 ausgefüllt werden, so daß die von der Kunststoffoberfläche bis zur Kunststoffunterseite gemessene Dicke der Dicke des Kartenkörpers 2 in etwa entspricht. Als Kunststoffmaterial kommen Siliconkautschuk, Epoxidharze oder Thermoplaste in Frage. Das Vergießen oder Verpressen kann vor dem Einbau der Einheit in den Kartenträger 2 in einer Form vorgenommen werden. Es ist aber auch möglich, die Guß- oder Preßmasse durch eine der Deckfolien 25 oder 26 in den um den Halbleiterchip 5 herum befindlichen Hohlraum einzubringen. Wegen der Flexibilität des verwendeten Mikropacks ist es aber auch möglich, in einer Ausführungsform mit offener Bauweise den den Halbleiterchip 5 umgebenden Hohlraum unausgefüllt zu lassen.

Ein weiteres Ausführungsbeispiel für die einpaßbare Einheit 1 in der der Fig. 3 entsprechenden Darstellung zeigt die Fig. 5. Die Anordnung von Anschlußbereichen 3, Leiternetz 6, Kunststoffzwischenträger 7, Trägerfolie 9 und Halbleiterchip 5 entspricht der in der Fig. 3 gezeigten Anordnung. Zusätzlich ist diese Anordnung dadurch versteift, daß an ihrer Unterseite eine als Bodenfolie 28 ausgeführte Bodenanordnung z. B. mittels Laminieren angeordnet ist. Die Bodenfolie 28 ist so dimensioniert, daß
sie in die fensterartige Aussparung 21 einpaßbar ist.
Die Oberseite der einpaßbaren Einheit 1 ist zum Abdichten
des um den Halbleiterchip 5 befindlichen Hohlraums und
zur Herstellung einer bis auf die erhöhten Anschlußbereiche 3 ebenen Oberfläche der Einheit 1 mit einer Deckelfolie 27 versehen, deren Dicke z. B. in etwa der Dicke
des Leiternetzes 6 entspricht und die beispielsweise dort
Aussparungen aufweist, wo auf der Oberfläche des Kunststoffzwischenträgers 7 das Leiternetz 6 angeordnet ist.

Der um den Halbleiterchip 5 befindliche Hohlraum kann entweder frei bleiben oder entsprechend den Ausführungen zur
Fig. 4 vergossen oder verpreßt werden.

Die einpaßbare Einheit 1 nach Fig. 5 wird entsprechend
den zur Fig. 4 gemachten Ausführungen in die Aussparung 21
des Kartenträgers 2 eingepaßt und an ihrer Unterseite mit
einer ersten Deckfolie 26 und an ihrer Oberseite mit
einer zweiten Deckfolie 25 versehen und bildet dann die
erfindungsgemäße, eine ebene Oberfläche aufweisende tragbare Karte 4.

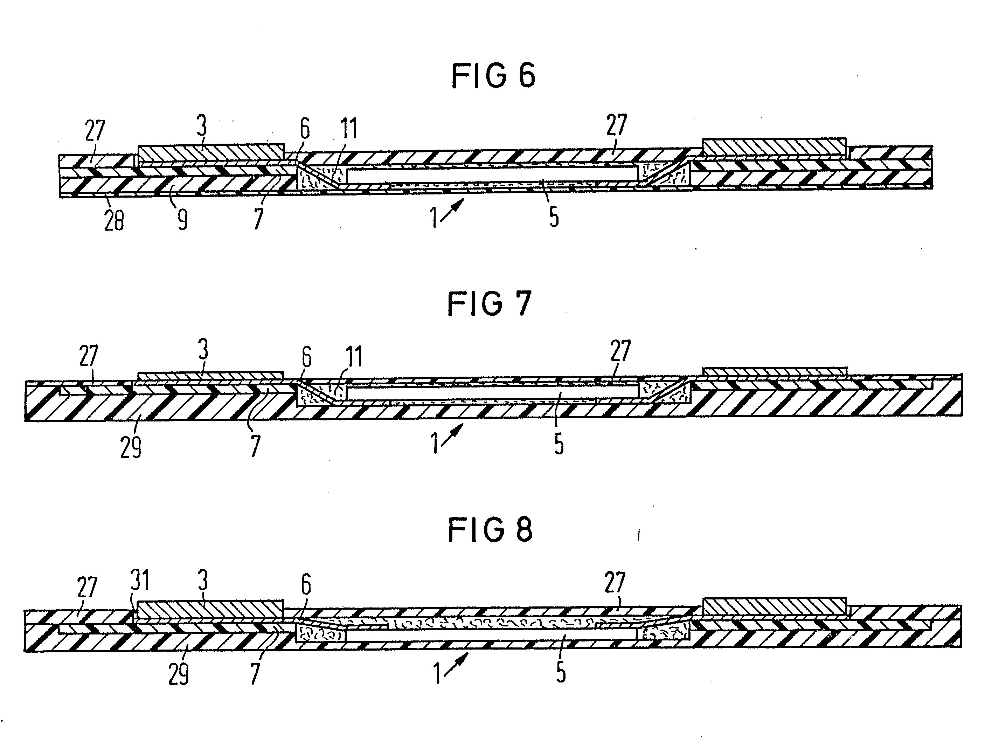

Ein weiteres Ausführungsbeispiel für die einpaßbare
Einheit 1 zeigt die Fig. 6. Sie entspricht im wesentlichen
dem Ausführungsbeispiel der Fig. 5, jedoch sind hier die
äußeren Anschlußbereiche 3 im Vergleich zu den in der
Fig. 5 gezeigten verdickt, z. B. statt 0,1 mm 0,2 mm dick.
Als Deckelfolie 27 und Trägerfolie 9 können dann beispielsweise gleichstarke Laminate verwendet werden. Die einpaßbare Einheit 1 ist auf ihrer Unterseite ebenfalls mit
einer Bodenfolie 28 abgeschlossen.

In den in den Figuren 7 und 8 gezeigten Ausführungsbeispielen für die einpaßbare Einheit 1 ist anstelle einer Bodenfolie 28 ein mit einem eine größere Fläche als der Halbleiterchip 5 aufweisenden Hohlraum 30 versehenes Formstück 29 vorgesehen. Das Formstück 29 kann so geformt sein, daß es einen weiteren stufenartigen Hohlraum zur Aufnahme des Kunststoffzwischenträgers 7 aufweist. Das Formstück 29 kann als vorgefertigtes Teil als Kunststoffspritzteil oder Kunststoffgießteil gefertigt sein, es kann aber auch als geprägte Thermoplastfolie hergestellt werden. Entsprechend den Figuren 5 und 6 wird die Oberseite der Einheit 1 mit einer dünnen (Fig. 7) Deckelfolie 27 oder bei verstärkter Ausführung der Anschlußbereiche 3 (vgl. Fig. 6) mit einer etwas dickeren Deckelfolie 27 (Fig. 8) versehen. Der Chip 5 ist in der Fig. 7 so in die Einheit 1 eingebaut, daß sich seine lötfähigen Anschlüsse 17 auf seiner Unterseite befinden.

Es ist aber - dies gilt auch für die Ausführungsbeispiele der Figuren 3 bis 6 - auch möglich, den Halbleiterchip 5 in der Weise in die Einheit 1 einzubauen, daß die lötfähigen Anschlüsse 17 wie im Ausführungsbeispiel der Fig. 8 nach oben zeigen.

Der um den Halbleiterchip 5 herum befindliche Hohlraum kann bei den Ausführungsbeispielen nach Figuren 7 und 8 entweder frei bleiben oder in einer der oben beschriebenen Weisen mit Kunststoff ausgefüllt werden.

In einer weiteren nicht figürlich dargestellten Ausführungsform ist es vorgesehen, die treppenartige Form des Formstücks 29 durch das Aufeinanderlaminieren dreier Kunststofffolien zu erhalten.

Die in Figuren 3 bis 8 gezeigten Ausführungsbeispiele für die einpaßbare Einheit 1 sind als einheitliches Teil, das bis auf die erhöhten Außenbereiche 3 glatt ist, ausgeführt. Die einpaßbare Einheit 1 kann jeweils der Fig. 4 entsprechend mit erster Deckfolie 26, Kartenträger 2 und zweiter Deckfolie 25 zur tragbaren Karte 4, die glatte Oberflächen aufweist, zusammengebaut werden. Die Dicken der Deckfolien 25 und insbesondere 26 sind dabei so zu wählen, daß die Gesamtdicke der Karte z. B. einer gewünschten Norm entspricht.

Befindet sich die tragbare Karte 4 nicht in einem Lesegerät, so weist der Halbleiterchip 5 keine Masseverbindung auf, so daß die Gefahr elektrostatischer Aufladungen besteht, die insbesondere bei Verwendung eines MOS-Chips zur Zerstörung des Halbleiterchips 5 führen können. Um hier Abhilfe zu schaffen, empfiehlt es sich, in Weiterbildung der Erfindung auf mindestens einer Oberfläche der Einheit 1 eine elektrisch leitende Schicht vorzusehen oder mindestens eine Oberflächenanordnung der Einheit 1 elektrisch leitend auszuführen. Die elektrisch leitende Schicht bzw. Oberfläche wird mit dem, den Massekontakt bildenden äußeren Anschlußbereich 3 elektrisch leitend verbunden. Vorteilhafterweise kann die Einheit 1 in der Weise ganzflächig, d. h. beidseitig, mit der elektrisch leitenden Schicht versehen werden, daß lediglich die Bereiche der äußeren Anschlußbereiche 3, die nicht als Massekontakt dienen, von der elektrisch leitenden Schicht ausgespart sind.

Entsprechend diesen Ausführungen kann beispielsweise die Bodenfolie 28 oder die Deckelfolie 27 oder beide Folien nach den Figuren 5 und 6 aus elektrisch leitendem Material hergestellt sein. Wird eine Deckelfolie 27 aus elektrisch leitendem Material verwendet, so ist darauf zu achten, daß die Deckelfolie 27 von den äußeren Anschlußbereichen 3, die nicht den Massekontakt bilden, elektrisch isolierend
angeordnet ist. Dies kann z. B. durch Anordnung einer in
der Dicke  der Deckelfolie 27 entsprechenden Isolierschicht 31 um die entsprechenden Anschlußbereiche 3 herum
bewirkt werden.

Wird bei der Ausführungsform nach Fig. 8 das Formstück 29
aus einem elektrisch leitenden Material hergestellt, so
kann eine weitere Verringerung des Aufladeproblems dadurch
erreicht werden, daß die Rückseite 16 des Halbleiterchips 5
ebenfalls metallisiert ausgeführt ist und z. B. mittels
eines elektrisch leitenden Klebers auf die Oberseite des
Formstücks 29 geklebt wird und somit ebenfalls mit dem
Massekontakt des Chips 5 verbunden ist.

Es ist auch möglich, die Karte 4 so auszuführen, daß
mindestens eine  Oberseite der Karte  mit einer elektrisch
leitenden Schicht versehen ist, die mit dem, den Massekontakt bildenden äußeren Anschlußbereich 3 elektrisch
leitend verbunden ist. Die elektrisch leitende Schicht ist
in einfacher Weise in der Weise zu realisieren, daß die
erste Deckfolie 26 und/oder die zweite Deckfolie 25 aus
elektrisch leitendem Material hergestellt sind. Bezüglich
der Isolierung der nicht als Massekontakt vorgesehenen
äußeren Anschlußbereiche 3 gilt das Obengesagte.

Die elektrisch leitenden Schichten können aus metallisiertem
Kunststoff bestehen, der als Deckfolie angebracht wird.
Sie können auch durch Aufdampfen, Aufdrucken oder bei
aktiviertem Polyimid mittels eines galvanischen Verfahrens
auf die verwendeten Kunststoffolien aufgebracht werden.
Weiterhin ist es möglich, Metallfolien zu verwenden oder
das Formstück 29 aus Metall zu fertigen.

Durch den erfindungsgemäßen Aufbau der tragbaren Karte 4 gelingt es, in wirtschaftlich günstiger Weise eine den Halbleiterchip 5 und die zum Außenanschluß notwendigen äußeren Anschlußbereiche 3 enthaltende Einheit 1 vorzusehen, die separat von den Folien 25 und 27 und dem Kartenträger 2 hergestellt und geprüft werden kann, und die als einheitliches Teil, das bis auf die erhöhten äußeren Anschlußbereiche 3 glatt ausgeführt und somit gut handhabbar ist, ausgeführt ist, wobei die Einheit 1 mit geringem Aufwand zur Karte 4 weiterverarbeitet werden kann.

8 Figuren
16 Patentansprüche

Patentansprüche

1. Tragbare Karte zur Informationsverarbeitung mit einem in der Karte angeordneten Halbleiterchip (5) und mit äußeren Anschlußbereichen (3), die mit den Kontaktierungsflächen (17) des Halbleiterchips (5) durch ein Leiternetz (6) verbunden sind, dadurch g e k e n n z e i c h n e t , daß der Halbleiterchip (5) in Form eines Mikropacks, bestehend aus einem Kunststoffzwischenträger (7), der mit einem eine größere Fläche als der Halbleiterchip (5) aufweisenden Fenster (8) versehen ist und der einseitig mit einem metallischen Leiternetz (6) versehen ist, dessen zum Kontaktieren der Kontaktierungsflächen (17) bestimmte Anschlußfinger (18) in das Fenster (8) hineinragen, wobei die Kontaktierungsflächen (17) des Halbleiterchips (5) zur elektrischen Kontaktierung und zur mechanischen Halterung des Chips (5) mit dem in das Fenster (8) hineinragenden Enden der Anschlußfinger (18) kontaktiert sind, in der aus einem Kartenkörper (2) und mindestens einer Deckfolie (25) bestehenden Karte (4) angeordnet ist und daß das Mikropack als in eine fensterartige Aussparung (21) des Kartenkörpers (2) einpaßbare Einheit (1), deren Dicke in etwa der Dicke des Kartenkörpers (2) entspricht und auf deren einer Oberfläche die äußeren Anschlußbereiche (3) angeordnet sind, hergestellt ist.

2. Tragbare Karte nach Anspruch 1, dadurch g e k e n n - z e i c h n e t , daß auf der Unterseite der aus Kartenkörper (2) und einpaßbarer Einheit (1) gebildeten Anordnung eine erste Deckfolie (26) angeordnet ist.

3. Tragbare Karte nach Anspruch 1 oder 2, dadurch g e - k e n n z e i c h n e t , daß auf der Oberseite der aus Kartenkörper (2) und einpaßbarer Einheit (1) gebildeten

0071255

Anordnung eine zweite, die Anschlußbereiche (3) aussparende Deckfolie (25) angeordnet ist.

4. Tragbare Karte nach einem der Ansprüche 1 bis 3, dadurch gekennzeichnet , daß Hohlräume zwischen erster und zweiter Deckfolie (26, 25) mit Kunststoff (11) ausgefüllt sind.

5. Tragbare Karte nach einem der Ansprüche 1 bis 4, dadurch gekennzeichnet , daß der Kunststoffzwischenträger (7) auf einer, in die fensterartige Aussparung (21) einpaßbaren, das Unterteil der einpaßbaren Einheit (1) bildenden Bodenanordnung (28) angeordnet ist.

6. Tragbare Karte nach einem der Ansprüche 1 bis 5, dadurch gekennzeichnet , daß zwischen Kunststoffzwischenträger (7) und Bodenanordnung (28, 29) eine Trägerfolie (9) angeordnet ist.

7. Tragbare Karte nach einem der Ansprüche 1 bis 6, dadurch gekennzeichnet , daß über dem Kunststoffzwischenträger (7) eine die äußeren Anschlußbereiche (3) aussparende in die fensterartige Aussparung (21) einpaßbare und das Oberteil der einpaßbaren Einheit (1) bildende Deckelfolie (27) angeordnet ist.

8. Tragbare Karte nach einem der Ansprüche 1 bis 7, dadurch gekennzeichnet , daß als Bodenanordnung eine Bodenfolie (28) vorgesehen ist.

9. Tragbare Karte nach einem der Ansprüche 1 bis 8, dadurch gekennzeichnet , daß als Bodenanordnung ein mit einem eine größere Fläche als der Halbleiterchip (5) aufweisenden Hohlraum (30) versehenes Formstück (29) vorgesehen ist.

10. Tragbare Karte nach einem der Ansprüche 1 bis 9, d a d u r c h   g e k e n n z e i c h n e t , daß die mit dem Leiternetz (6) verbundenen, auf dem Kunststoffzwischenträger (7) befindlichen äußeren Anschlußbereiche (3) in ihrer Dicke verstärkt sind.

11. Tragbare Karte nach einem der Ansprüche 1 bis 10, d a d u r c h   g e k e n n z e i c h n e t , daß die äußeren Anschlußbereiche (3) so verstärkt sind, daß die aus den verstärkten äußeren Anschlußbereichen (3) und der zweiten Deckfolie (25) bestehende Oberfläche der Karte (4) plan ist.

12. Tragbare Karte nach einem der Ansprüche 1 bis 11, d a d u r c h   g e k e n n z e i c h n e t , daß die Bodenanordnung (28, 29) mindestens teilweise aus elektrisch leitendem Material hergestellt ist.

13. Tragbare Karte nach einem der Ansprüche 1 bis 12, d a d u r c h   g e k e n n z e i c h n e t , daß die Deckelfolie (27) mindestens teilweise aus elektrisch leitendem Material hergestellt ist.

14. Tragbare Karte nach einem der Ansprüche 1 bis 13, d a d u r c h   g e k e n n z e i c h n e t , daß die metallisierte Rückseite (16) des Halbleiterchips (5) an der mindestens teilweise aus elektrisch leitendem Material hergestellten Folie oder Anordnung (28, 29) elektrisch leitend angeordnet ist.

15. Tragbare Karte nach einem der Ansprüche 1 bis 14, d a d u r c h   g e k e n n z e i c h n e t , daß mindestens eine Deckfolie (25, 26) mindestens teilweise aus elektrisch leitendem Material hergestellt ist.

16. Tragbare Karte nach einem der Ansprüche 1 bis 15, d a d u r c h   g e k e n n z e i c h n e t ,   daß die mindestens teilweise aus elektrisch leitendem Material hergestellte Folie oder Anordnung (25, 26, 27, 28, 29) mit dem den Massekontakt bildenden äußeren Anschlußbereich (3) elektrisch leitend verbunden ist.

FIG 1

FIG 2

FIG 3

FIG 4

FIG 5

# FIG 6

27  3  6  11  27

28  9  7  1  5

# FIG 7

27  3  6  11  27

29  7  1  5

# FIG 8

27  31  3  6  27

29  7  1  5

0071255